# EUROPÄISCHE PATENTSCHRIFT

(11) **EP 0 732 537 B1**
(45) Veröffentlichungstag und Bekanntmachung des Hinweises auf die Patenterteilung: **09.02.2000**
(21) Anmeldenummer: 96103010.3
(22) Anmeldetag: 29.02.1996
(51) Int. Cl.: F21V 3/00, F21V 17/04, F21V 19/00

(54) **Lampe mit farbiger Silikonkappe**
Lamp with a coloured silicone cap
Lampe avec cabochon coloré en silicone

(30) Priorität: 03.03.1995 DE 19507518
(43) Veröffentlichungstag der Anmeldung: 18.09.1996
(73) Patentinhaber: SLI Miniature Lighting GmbH & Co. KG, 96052 Bamberg (DE)
(72) Erfinder: Arnold, Werner, 96049 Bamberg (DE)
(74) Vertreter: Matschkur, Lindner Blaumeier Patent- und Rechtsanwälte

(56) Entgegenhaltungen:
- DE-U- 7 442 501
- GB-A- 2 258 301

## Beschreibung

Die Erfindung bezieht sich auf eine Lampe mit einer gummielastischen Kappe, insbesondere einer farbigen Silikonkappe, insbesondere zur Befestigung auf Leiterplatten durch Einlöten der am Boden des Glaskolbens austretenden Lampenanschlußdrähte, wie es z.B. in der Patentanmeldung GB-A-2258301 gezeigt wird. Um verschiedenfarbige Anzeigen, beispielsweise auf Armaturenbrettern oder sonstigen Anzeigepaneelen, zu erzielen, geht man unter anderem von farblosen Lämpchen aus, die durch aufgezogene farbige Silikonkappen in entsprechender Weise abgeändert werden.

Bei der üblichen Befestigung solcher Lampen durch Einstecken der aus dem Boden des Glaskolbens herausragenden Lampenanschlußdrähte in entsprechende Bohrungen der Leiterplatte und anschließendes Schwallbadverlöten ergibt sich die Gefahr, daß die Lampen im Schwallbad durch den Lötvorgang kippen, so daß sie nach dem Löten schief in der Leiterplatte sitzen. Für viele Anwendungen ist dies hinsichtlich der Ausleuchtung oder aus Montagegründen nachteilig. Deshalb muß dann ein manueller Richtvorgang erfolgen. Außer den erheblichen hierfür anfallenden Kosten besteht dabei die Gefahr, daß die Einschmelzung der Lampe beschädigt wird und es zu sog. Luftziehern kommen kann, was letztlich zum Lampenausfall führt.

Um diese Schwierigkeiten zu beseitigen ist es bereits vorgeschlagen worden, auf die Lampen zunächst im unteren Bereich eine Kunststoffhülse aufzubringen, die als Standhülse beim Aufsetzen auf die Leiterplatte wirkt, wobei bei farbigen Lampen dann über den Glaskolben und die ihn im unteren Teil umgebende Kunststoffhülse die eigentliche farbige Silikonkappe aufgezogen wird.

Dies ist aber ebenfalls wiederum äußerst mühsam, da es nicht nur den zusätzlichen Schritt des Aufbringens einer Kunststoffkappe erfordert, sondern darüber hinaus auch das anschließende Aufziehen der Silikonkappe erschwert ist, da diese nicht nur das Lämpchen dicht umgeben muß und demzufolge nicht zu groß ausgebildet sein kann, sondern auch noch über die dickere Kunststoffkappe gezogen werden muß.

Der Erfindung liegt daher die Aufgabe zugrunde, eine Lampe der eingangs genannten Art so auszugestalten, daß sie bei einfachem Aufbau und einfacher Montage gegen Verkippungen beim Befestigen und insbesondere Anlöten auf Leiterplatten gesichert ist.

Zur Lösung dieser Aufgabe ist erfindungsgemäß vorgesehen, daß die Kappe mit einer den unteren Abschnitt des Glaskolbens überdeckenden, nach unten über den Glaskolbenboden als Aufstellrand überstehenden Randverdickung versehen ist, wobei bevorzugt die Kappe im Bereich des Aufstellrandes zusätzlich eine die Lampe in der Kappe - im folgenden wird der Einfachheit halber immer von der bevorzugten Silikonkappe gesprochen - fixierende, den Glaskolben untergreifende nach innen weisende Randschulter aufweist, und daß die Lampenanschlußdrähte derart nach unten schräggestellt und/oder gebogen- sind, daß sie nach dem Einstecken in die Bohrungen der Leiterplatte den Aufstellrand gegen diese verspannen.

Es hat sich nämlich gezeigt, daß eine Verdickung der Silikonkappe, die an sich ein sehr flexibles Material darstellt, einen ausreichend stabilen Aufstellrand ergibt, der für die angesprochenen Zwecke der Verhinderung einer Verkippung der Lampe bei der Befestigung auf der Leiterplatte völlig ausreicht. Es kommt also gar nicht darauf an, daß man einen Aufstellrand in Form einer extra aufgebrachten Kunststoffkappe hat oder gar das Lämpchen zunächst in einem Kunststoffsockel befestigt. Für die erfindungsgemäße Kippverhinderung reicht eine Randverdickung der flexiblen Silikonkappe aus. Dabei ist es lediglich von Bedeutung, daß diese Randverdickung nicht erst unterhalb des Lämpchens beginnt, sondern sich teilweise über den unteren Abschnitt des Glaskolbens erstreckt, um auf diese Art und Weise eine Stabilisierung der flexiblen Randverdickung zu erzielen.

Zur Vorfixierung des Lämpchens vor dem Einlöten der Lampenanschlußdrähte ist dabei das zweite Merkmal von Bedeutung, daß die federnd elastisch ausgebildeten Lampenanschlußdrähte derart nach unten schräggestellt und/oder gebogen sind, daß sie nach dem Einstecken in die Bohrungen der Leiterplatte den Aufstellrand gegen diese verspannen, indem sich ein Schrägabschnitt der Lampenanschlußdrähte an die Unterkante der Einsteckbohrung anlegt und damit diese Verspannung bewirkt. Dabei ergibt sich über die Elastizität der frei über den Glaskolben nach unten überstehenden Kappe auch ein Ausgleich der Toleranzen der Leiterplatte.

Die Erfindung soll nachstehend an einem Ausführungsbeispiel sowie anhand der Zeichnung näher erläutert werden. Dabei zeigen:
- Fig. 1 und 2: Ausführungsbeispiele handelsüblicher Lampen mit farbigen Silikonkappen, und
- Fig. 3: eine teilweise geschnittene Seitenansicht eines Lämpchens mit einer erfindungsgemäßen farbigen Silikonkappe mit Aufstellrand.

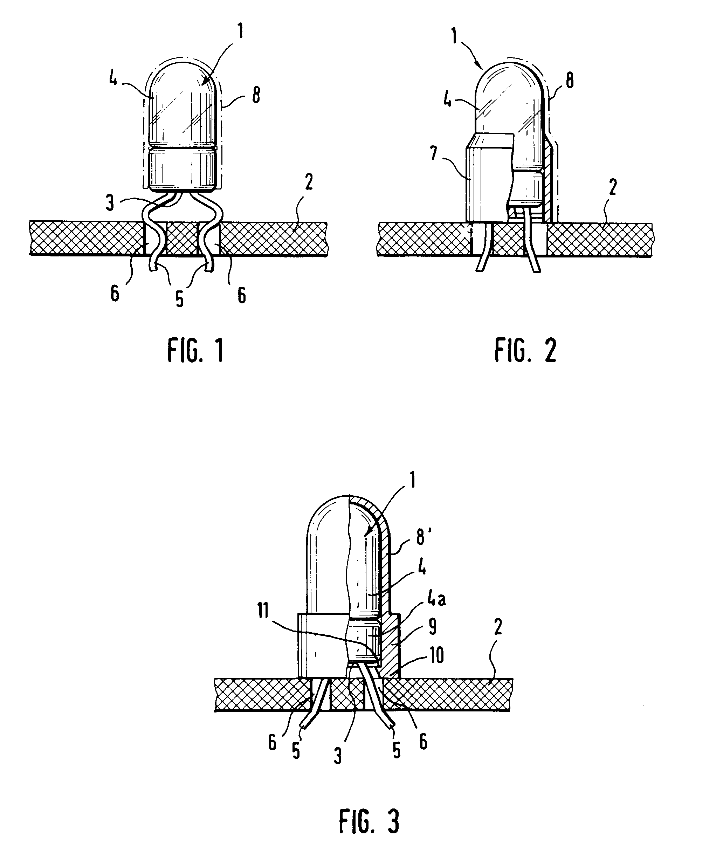

In Fig. 1 ist die übliche Ausführungsform eines Lämpchens 1 zur Montage in einer Leiterplatte 2 gezeigt, wobei die den Boden 3 des Glaskolbens 4 des Lämpchens 1 durchsetzenden Lampenanschlußdrähte 5 durch entsprechende Bohrungen 6 der Leiterplatte gesteckt sind, in denen sie nach der Montage aller Lämpchen und sonstigen Bauteile durch Schwallbadlöten kontaktierend befestigt werden. Durch die üblicherweise größeren Abstände der Bohrungen 6 gegenüber den Abständen der Lampenanschlußdrähte 5 beim Austritt aus dem Boden 3 ergibt sich die zwangsweise Notwendigkeit, das Lämpchen 1 so oberhalb der Leiteranschlußplatte 2 zu positionieren, daß ein Abstand zwischen dem Boden und der Leiterplatte 2 gegeben ist, das Lämpchen also nicht direkt auf der Leiterplatte aufsitzen kann. Dies wiederum hat zur Folge, daß vor oder bei dem Löten das Lämpchen kippen kann und dann nach dem Löten keine exakte Ausrichtung des Lämpchens mehr gegeben ist.

Um dies zu vermeiden, hat man bereits vorgeschlagen, auf das Lämpchen 1 (vgl. Fig. 2) eine Kunststoffhülse 7 aufzubringen, die als Aufstellhülse nach unten übersteht. Bei der Notwendigkeit farbiger Lämpchen wurde dann über den Glaskolben 4 und die Kunststoffhülse 7 eine farbige Silikonkappe 8 gezogen, wie auch in Fig. 1 eine solche Silikonkappe 8 in der handelsüblichen Form zur farbigen Ausgestaltung der Lampe mit angedeutet ist. Dieses Aufbringen einer farbigen Silikonkappe ist bei der Anordnung nach Fig. 2 durch den Kunststoffsockel 7 erschwert, der eine entsprechend stärkere Aufweitung des flexiblen Silikonmaterials zum Aufbringen auch über die Kunststoffhülse 7 erforderlich macht.

Bei der erfindungsgemäßen Konstruktion nach Fig. 3 ist auf das Lämpchen 1 eine farbige Silikonkappe 8' aufgebracht, die mit einer Randverdickung 9 versehen ist, die zum einen den unteren Bereich 4a des Glaskolbens 4 übergreift und zum anderen nach unten über den Boden 3 des Glaskolbens als Aufstellrand 10 zum Aufstellen auf die Leiterplatte 2 übersteht.

Die Fertigung von solchen farbigen Silikonkappen mit einer Randverdickung 9 ist gegenüber der Herstellung der einfachen bisher verwendeten Silikonkappen 8 nicht nennenswert verkompliziert, es ergibt sich jedoch gegenüber der bisherigen kippgesicherten Anordnung, wie sie in Fig. 2 gezeigt ist, ein erheblich einfacherer Aufbau und insbesondere eine erheblich einfachere Montage. Die Ausbildung der Randverdickung 9 mit einer größeren Wandstärke als der üblichen Wandstärke von Kunststoffhülsen 7, wie sie in Fig. 2 verwendet werden, gleicht die erheblich größere Flexibilität von Silikon gegenüber Kunststoff teilweise aus. Zum anderen nutzt die Erfindung die Tatsache aus, daß es ja nicht auf eine absolut starre Standkappe ankommt, sondern daß lediglich eine ein Verkippen verhindernde Vorfixierung notwendig ist, bis durch das Verlöten der Anschlußdrähte 5 die endgültige Halterung der Lampe erzielt wird.

In der Fig. 3 erkennt man, daß die Verdickung 9 im Bereich des Aufstellrandes 10 sich auch nach innen unter Bildung einer Randschulter 11 erstreckt, die den Boden 3 des Glaskolbens 4 untergreift. Darüber hinaus erkennt man in dieser Figur eine Schrägstellung der Lampenanschlußdrähte 5 gegeneinander, sowie eine Biegung der Lampenanschlußdrähte, die - selbstverständlich abgestimmt auf den Abstand der Einstecköffnungen 6 - so gewählt ist, daß die federnd elastisch ausgebildeten Lampenanschlußdrähte 5 in der gezeigten Weise an den Unterkanten der Einstecköffnungen 6 anliegen und auf diese Art und Weise das Lämpchen an die Oberseite 12 der Leiterplatte 2 heranziehen und damit eine Vorfixierung mit gegenüber der Leiterplatte 2 verspanntem Aufstellfuß 10 bewirken, so daß die Leiterplatte sogar auf den Kopf gestellt werden kann, ohne daß das Lämpchen herausfällt oder auch nur seine vertikale Orientierung zur Leiterplatte 2 verliert.

## Patentansprüche

1. Lampe mit farbiger Silikonkappe zur Befestigung auf Leiterplatten durch Einlöten der am Boden des Glaskolbens austretenden Lampenanschlußdrähte, wobei die Silikonkappe mit einer nach unten über den Glaskolbenboden überstehenden Randverdickung versehen ist, dadurch gekennzeichnet, daß die als Aufstellrand (10) dienende Randverdickung (9) den unteren Abschnitt (4a) des Glaskolbens (4) überdeckt und daß die Lampenanschlußdrähte (5) derart nach unten schräggestellt und/oder gebogen sind, daß sie nach dem Einstecken in die Bohrungen (6) der Leiterplatte (2) den Aufstellrand (10) gegen diese verspannen.

2. Lampe nach Anspruch 1, dadurch gekennzeichnet, daß die Silikonkappe (8') im Bereich des Aufstellrandes (10) eine die Lampe in der Silikonkappe (8') fixierende, den Glaskolben untergreifende nach innen weisende Randschulter (11) aufweist.

## Claims

1. Lamp with a coloured silicon cap for fixing to printed circuits by soldering in of the lamp connecting wires emerging from the bottom of the glass bulb, the silicon cap being provided with a peripheral thickening projecting at the bottom beyond the glass bulb base, characterised in that the peripheral thickening (9) acting as a standing edge (10) covers the lower section (4a) of the glass bulb and in that the lamp connecting wires (5) are placed obliquely and/or are bent at the bottom in such a manner that after insertion into the bores (6) of the printed circuit (2) they brace the standing edge (10) against the printed circuit (2).

2. Lamp according to claim 1, characterised in that the silicon cap (8') has in the region of the standing edge (10) a peripheral shoulder (11) which fixes the lamp in the silicon cap (8'), which engages under the glass bulb and which points inwards.

## Revendications

1. Lampe (1) comportant un capuchon en silicone coloré pour sa fixation sur des plaquettes à circuits imprimés par brasage des fils de raccordement de la lampe qui sortent au niveau de la base de l'ampoule de la lampe, le capuchon en silicone étant pourvu d'un épaississement marginal qui fait saillie vers le bas au-delà de la base de l'ampoule de verre, caractérisée en ce que l'épaississement marginal (9) utilisé en tant que bord d'appui (10) recouvre la partie inférieure (4a) de l'ampoule de verre (4) et que les fils (5) de raccordement de la lampe sont disposés obliquement et/ou repliés vers le bas de telle sorte qu'après leur enfichage dans les perçages (6) de la plaquette à circuits imprimés (2), ils serrent le bord d'appui (10) contre cette plaquette.

2. Lampe selon la revendication 1, caractérisé en ce que le capuchon en silicone (8') comporte, dans la zone du bord d'appui (10), un épaulement marginal (11) dirigé vers l'intérieur, qui fixe la lampe dans le capuchon en silicone (8') et s'engage au-dessous de l'ampoule de verre.
